# EUROPEAN PATENT SPECIFICATION

(11) **EP 0 718 898 B1**
(45) Date of publication and mention of the grant of the patent: **10.03.1999**
(21) Application number: 95119839.9
(22) Date of filing: 15.12.1995
(51) Int. Cl.: H01L 39/24

(54) **Compound superconducting wire**
Draht aus supraleitender Verbindung
Fil supraconducteur composite

(30) Priority: 20.12.1994 JP 316156/94; 29.09.1995 JP 253364/95
(43) Date of publication of application: 26.06.1996
(73) Proprietor: SUMITOMO ELECTRIC INDUSTRIES, LTD., Osaka-shi, Osaka 541 (JP)
(72) Inventor: Ayai, Naoki, c/o Osaka Works Sumitomo Elec.Ind.Ltd, Konohana-ku, Osaka-shi, Osaka (JP)
(74) Representative: Winter, Brandl, Fürniss, Hübner, Röss, Kaiser, Polte, Kindermann Partnerschaft

(56) References cited:
- EP-A- 0 405 405
- EP-A- 0 613 192
- GB-A- 2 092 043

## Description

### BACKGROUND OF THE INVENTION

### Field of the Invention

The present invention relates to a compound superconducting wire according to the preamble of claim 1, and more particularly, it relates to a compound superconducting wire serving as a high magnetic field superconducting material for a superconducting magnet or the like which is employed for superconducting energy storage, nuclear fusion or still another application.

### Description of the Background Art

A wire prepared from a compound superconducting material such as Nb₃Al, Nb₃Sn or V₃Ga, which can be employed for a high magnetic field application dissimilarly to an alloy superconducting material such as NbTi, is expected as a high magnetic field superconducting material. Among the aforementioned compound superconducting materials, Nb₃Al having a high critical magnetic field and a high critical temperature is particularly expected as an advanced high magnetic field material.

As to a method of preparing a wire from an Nb₃X superconducting material, on the other hand, study has been made on various methods such as a tube method, powder metallurgy and a jelly roll method according to GB-A-2 092 043, for exampes. As to such a method of preparing a wire of Nb₃Al, the jelly roll method is regarded as being most approximate to practical use at present, since copper stabilization and implementation of a multifilamentary state, which are inevitable for a practical wire, are readily performed.

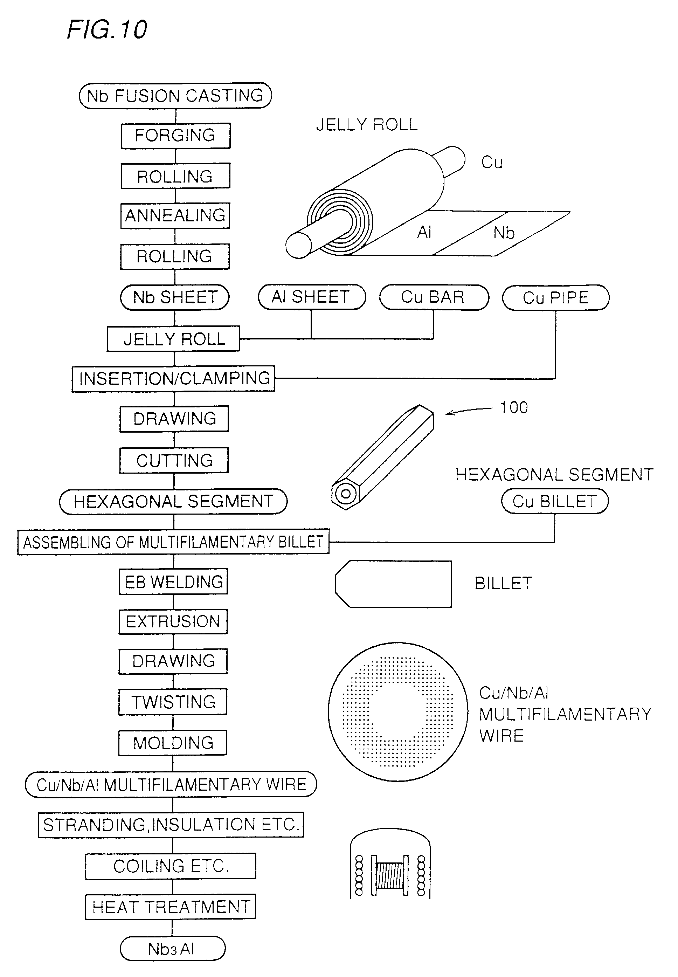

Fig. 10 is a step diagram schematically showing a method of preparing an Nb₃Al superconducting multifilamentary wire by the jelly roll method in accordance with EP 0 613 192 A1, for example.

Referring to Fig. 10, a high-purity Nb sheet and a high-purity Al sheet are first prepared by fusion and rolling. Then, the Nb sheet and the Al sheet are superposed with each other and rolled up around an oxygen free copper bar, to prepare a wire (jelly roll). Then, this wire is inserted in an oxygen free copper pipe, then drawn to be hexagonal in section, and thereafter cut into a desired length, thereby preparing a hexagonal segment 100. Then, a plurality of such hexagonal segments 100 are charged in a copper pipe for preparing a billet, which in turn is sealed up in a vacuum by electron beam welding, and extruded. A multifilamentary wire thus obtained is drawn, subjected to desired twisting, molding, stranding, insulation and the like, coiled and thereafter heat treated to form a superconducting phase (A15 type structure of Nb₃Al).

In the conventional jelly roll method, as hereinabove described, an Nb sheet consisting of Nb or an alloy containing Nb and an X sheet consisting of an element X forming a compound exhibiting superconductivity through reaction with Nb or an alloy containing the element X are lap-wound around a round bar consisting of copper or a copper alloy, thereby preparing a compound superconducting wire as a laminate.

In the conventional jelly roll method, however, it is difficult to reduce the filament diameter and hence high ac loss disadvantageously results from fluctuation of a current or an external magnetic field.

In order to reduce the filament diameter, the working rate may be increased. When the working rate is increased, however, the laminate is so frequently disconnected that a long wire cannot be obtained. In order to reduce the filament diameter while suppressing the working rate for preventing disconnection, the rolled laminate which is prepared by rolling up the raw material sheets must have a small diameter. To this end, it is advantageous to minimize the diameter of the material which is arranged at the center of the rolled laminate.

In the conventional technique employing a round bar as a core material, however, reduction of the diameter of the central bar is limited to about 60 times the thickness of the Nb sheet, due to high resistance in bending of the Nb sheet. When the diameter of the central bar is reduced, frictional force of the sheet against the central bar is so reduced that it is impossible to attain frictional force which is necessary for a prescribed roll-up operation. Thus, a long time is required for the roll-up step.

### SUMMARY OF THE INVENTION

Accordingly, an object of the present invention is to provide a structure of a compound superconducting wire which can readily roll up a rolled laminate while reducing the working time.

Another object of the present invention is to provide a structure of a compound superconducting wire which can further reduce the diameter of a bar body arranged at the center of a rolled laminate.

These objects are solved by the features of claim 1.

A compound superconducting wire according to the present invention comprises a bar body and a rolled laminate. The bar body has an outer peripheral surface. The rolled laminate is formed by superposing first and second sheets around the outer peripheral surface of the bar body and rolling up the same. The first sheet consists of at least one material which is selected from a group consisting of an Nb metal and an alloy containing Nb. The second sheet consists of at least one material which is selected from a group consisting of an element X forming a compound exhibiting superconductivity through reaction with Nb and an alloy containing the element X. The bar body holds an end portion of at least one sheet selected from a group consisting of the first and second sheets.

In addition, the bar body is formed by first and second bar bodies having semicircular cross sections. An end portion of at least one sheet and the first and second bar bodies are so combined with each other that the cross sections of the first and second bar bodies holding the end portion of at least one sheet define a substantially circular shape.

Preferably, end portions of the first and second sheets may be held between the first and second bar bodies.

Preferably, the bar body and at least one sheet may be directly or indirectly fixed to each other by clamping force of a screw.

Preferably, the element X is an element which is selected from a group consisting of Sn and Al.

Preferably, the bar body consists of a material which is selected from a group consisting of copper and a copper alloy.

Preferably, the first sheet is rolled up to be in contact with the outer peripheral surface of the bar body, while the second sheet is rolled up while being superposed on the first sheet.

According to a further preferred embodiment, the compound superconducting wire according to the present invention comprises the bar body having the aforementioned structure, the rolled laminate, and a stabilizing material layer which is arranged to enclose the rolled laminate.

In the aforementioned embodiment, preferably the bar body consists of copper or a copper alloy, the element X is Sn or Al, and the stabilizing material layer consists of copper or a copper alloy. The first sheet is rolled up to be in contact with the outer peripheral surface of the bar body and the stabilizing material layer as a diffusion barrier layer for suppressing the element X from diffusion in the stabilizing material layer.

In the compound superconducting wire according to the present invention, two or more bar bodies are employed as the center of the rolled laminate. An end portion of the first sheet containing Nb or the second sheet containing the element X, or those of both sheets are held between the two or more bar bodies, so that the first and second sheets are rolled up while being superposed with each other. Thus, the end portion(s) of the sheet(s) can be tightly fixed to the bar body(s). Consequently, the rolled laminate can be readily rolled up and the working time therefor can also be reduced.

The end portion(s) of the sheet(s) can be so tightly fixed to the bar body(s) that the roll-up operation can be readily performed even if frictional force between the sheet(s) and the bar body(s) is reduced due to reduction in diameter of the bar body(s). In other words, it is possible to further reduce the diameter(s) of the bar body(s) arranged at the center of the rolled laminate as compared with the prior art. Thus, the filament diameter can be so reduced that reduction of ac loss can be attained. Further, the rate occupied by the diffusion barrier layer for suppressing the X element from diffusion in the stabilizing material layer in the filament is reduced. Consequently, the critical current density is increased in portions excluding the copper portions.

Further, it is possible to form the diffusion barrier layer for suppressing mutual diffusion between the material forming the bar body(s) and the element X forming the second sheet by the first sheet of a prescribed thickness, by rolling up the first sheet containing Nb to be in contact with the outer peripheral surface(s) of the bar body(s).

When the first sheet is rolled up to be in contact with the stabilizing material layer, it is possible to form the diffusion barrier layer for suppressing mutual diffusion between copper forming the stabilizing material layer and the element X forming the second sheet by the first sheet having a prescribed thickness.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a perspective view showing arrangement relation between a copper bar and respective sheets for forming a wire according to an embodiment 1 of the present invention;
Fig. 2 is a sectional view showing a single-filamentary hexagonal segment according to the embodiment 1 of the present invention;
Fig. 3 is a sectional view showing a rolled laminate according to the embodiment 1 of the present invention;
Fig. 4 is a schematic sectional view showing a multifilamentary wire according to the embodiments of the present invention;
Fig. 5 is a perspective view showing arrangement relation between a copper bar and respective sheets for forming a wire according to an embodiment 2 of the present invention;
Fig. 6 is a sectional view showing a single-filamentary hexagonal segment according to the embodiment 2 of the present invention;
Fig. 7 is a perspective view showing arrangement relation between a copper bar and respective sheets for forming a wire according to an embodiment 3 of the present invention;
Fig. 8 is a sectional view showing a single-filamentary hexagonal segment according to the embodiment 3 of the present invention;
Fig. 9 is a perspective view showing arrangement relation between a copper bar and respective sheets for forming a wire according to an embodiment 4 of the present invention; and
Fig. 10 is a step diagram schematically showing a conventional method of preparing an Nb₃Al superconducting multifilamentary wire by a jelly roll method.

### DESCRIPTION OF THE PREFERRED EMBODIMENTS

### Embodiment 1

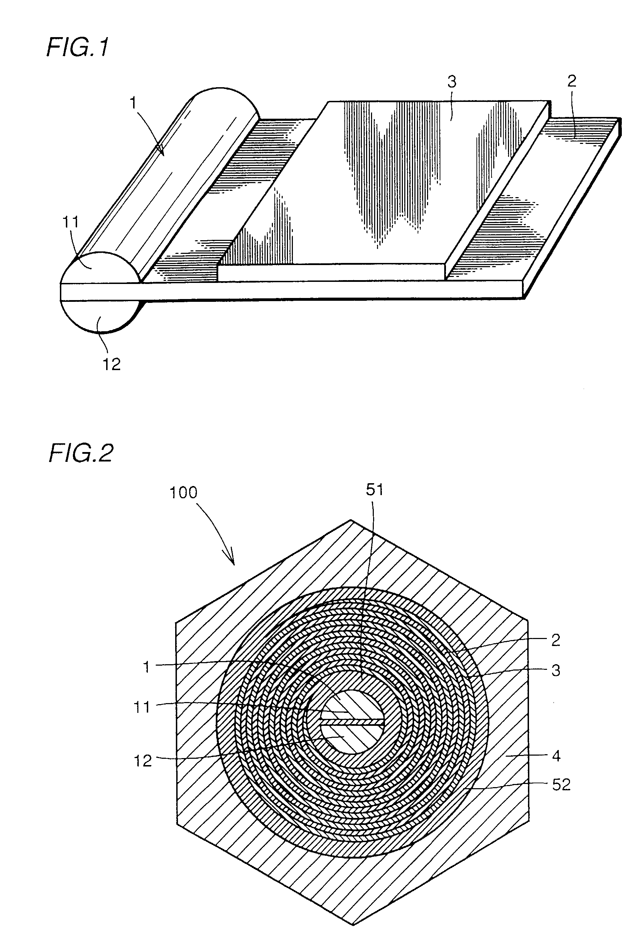

As shown in Fig. 1, a copper bar 1 which is arranged at the center of a rolled laminate is formed by two copper bars 11 and 12 having semicircular cross sections. An end portion of an Nb sheet 2 is held between the two copper bars 11 and 12. An Al sheet 3 is arranged on the Nb sheet 2. According to this embodiment, the length of the Al sheet 3 to be rolled up is smaller than that of the Nb sheet 2. The Nb sheet 2 and the Al sheet 3 are superposed with each other in such arrangement, and rolled up around the outer peripheral surface of the copper bar 1.

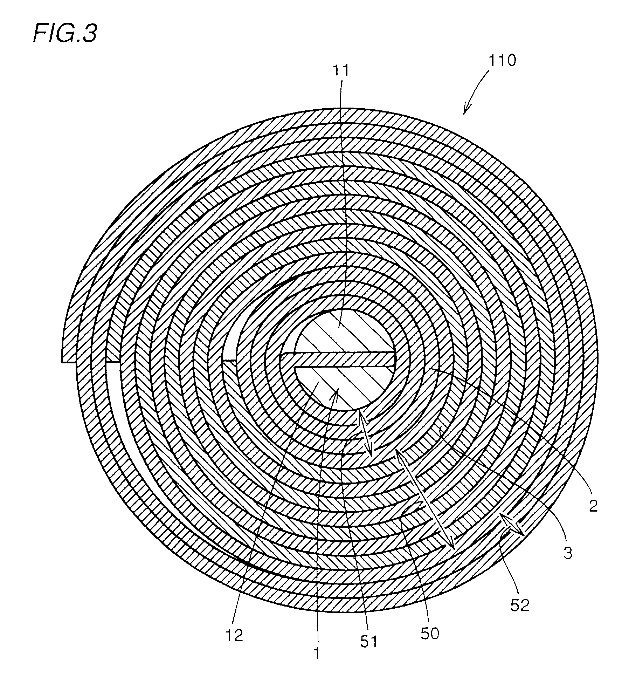

Fig. 3 shows a cross section of a superconducting wire obtained by roll-up working. As shown in Fig. 3, a rolled laminate 110 comprises a stacked portion 50 and diffusion barrier layers 51 and 52. The stacked portion 50 is formed by the Nb sheet 2 and the Al sheet 3 which are rolled up while being superposed with each other. The diffusion barrier layer 51 is formed by multiplex-rolling the Nb sheet 2, in order to suppress mutual diffusion of copper contained in the copper bar 1 and Al forming the Al sheet 3. The other diffusion barrier layer 52 is formed by multiplex-rolling the Nb sheet 2 for suppressing mutual diffusion of copper contained in a portion arranged on its outer side and Al forming the Al sheet 3. In order to form such diffusion barrier layers 51 and 52 by the Nb sheet 2, the Nb sheet 2 is so arranged that its length is larger than that of the Al sheet 3 in Fig. 1.

The rolled laminate 110 which is formed by the aforementioned roll-up working is drawn after its outer peripheral portion is coated with a copper material 4. Then, a wire is formed in prescribed dimensions, to have a hexagonal outer cross section. Fig. 2 shows a section thus obtained. A single-filamentary hexagonal segment 100 is formed as shown in Fig. 2.

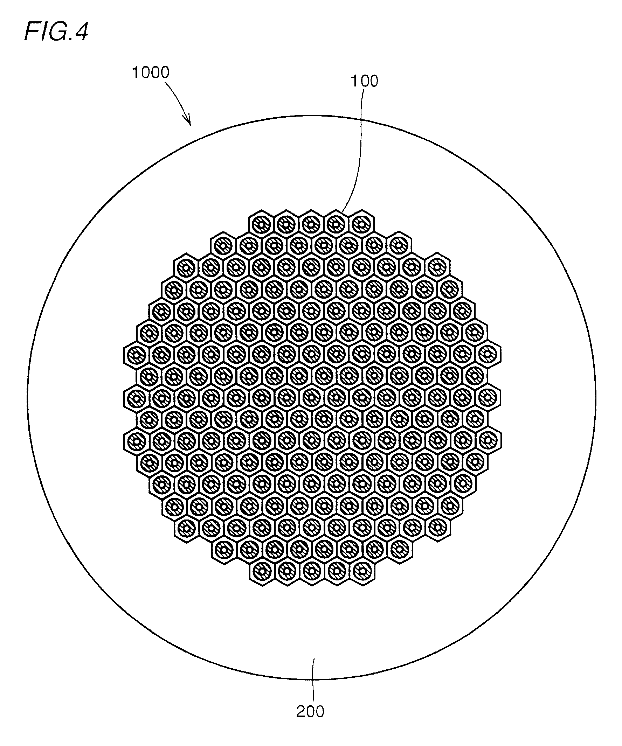

A number of such single-filamentary hexagonal segments 100 are bundled, arranged in a copper matrix, and subjected to drawing, thereby forming a multifilamentary wire. Fig. 4 shows a multifilamentary wire 1000 obtained in the aforementioned manner. In this multifilamentary wire 1000, a number of single-filamentary hexagonal segments 100 are arranged in a copper matrix 200.
Referring to Fig. 4, hatched portions correspond to filaments.

Thus, it is possible to tightly fix the end portion of the Nb sheet 2 to the bar 1 by holding the same between the two copper bars 11 and 12 and rolling up the Nb sheet 2 and the Al sheet 3. Therefore, the rolled laminate 110 can be readily rolled up and the time required for such roll-up working can also be reduced.

Further, the diameter of the copper bar 1 which is positioned at the center of the rolled laminate 110 can be reduced. Thus, the outer diameters of the filaments (hatched portions in Fig. 4) can be reduced in the multifilamentary wire 1000 shown in Fig. 4, whereby reduction of ac loss can be attained.

Further, the rate occupied by the diffusion barrier layers for suppressing Al from diffusion in the stabilizing copper arranged at the center and the outer peripheral portion of each filament is reduced. Consequently, the critical current density is increased in portions excluding the copper portions.

### Embodiment 2

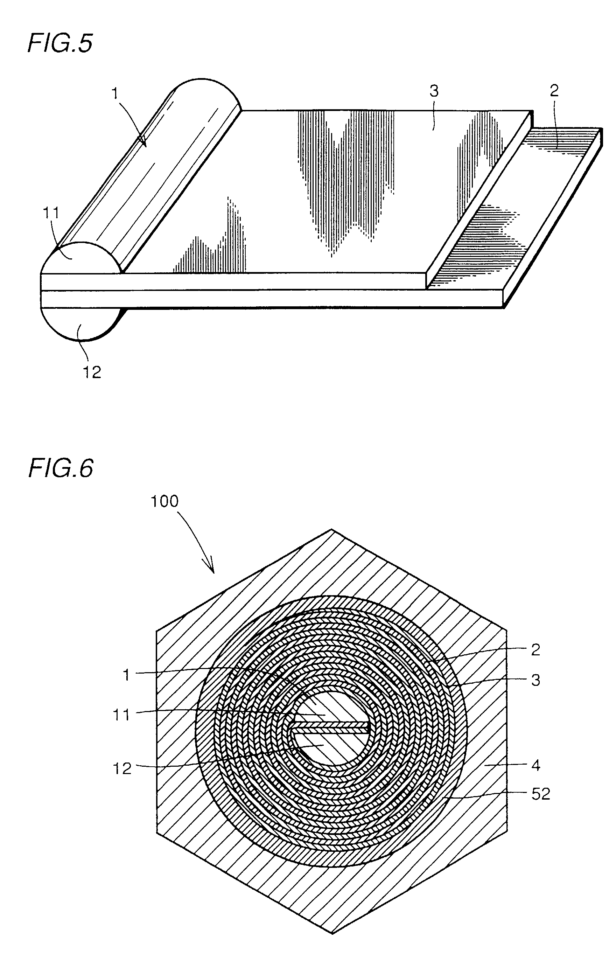

As shown in Fig. 5, a copper bar 1 comprises two copper bars 11 and 12 having semicircular cross sections. Single end portions of an Nb sheet 2 and an Al sheet 3 are held between the two copper bars 11 and 12. The Al sheet 3 is superposed on the Nb sheet 2. The length of the Nb sheet 2 to be rolled up is larger than that of the Al sheet 3.

The Nb sheet 2 and the Al sheet 3 which are arranged in the aforementioned manner are superposed with each other and rolled up around the outer peripheral surface of the copper bar 1, whereby a single-filamentary hexagonal segment 100 shown in Fig. 6 can be obtained. The other end portion of the Nb sheet 2 extending beyond the Al sheet 3 forms a diffusion barrier layer 52 on the outer peripheral portion of the rolled laminate. A copper material 4 is arranged around the diffusion barrier layer 52, and its outer peripheral section is formed in a hexagonal shape.

Similarly to the embodiment 1, the multifilamentary wire 1000 shown in Fig. 4 can be prepared from a number of the single-filamentary hexagonal segments 100 shown in Fig. 6. A function and an effect which are similar to those of the embodiment 1 can be attained also in the embodiment 2.

### Embodiment 3

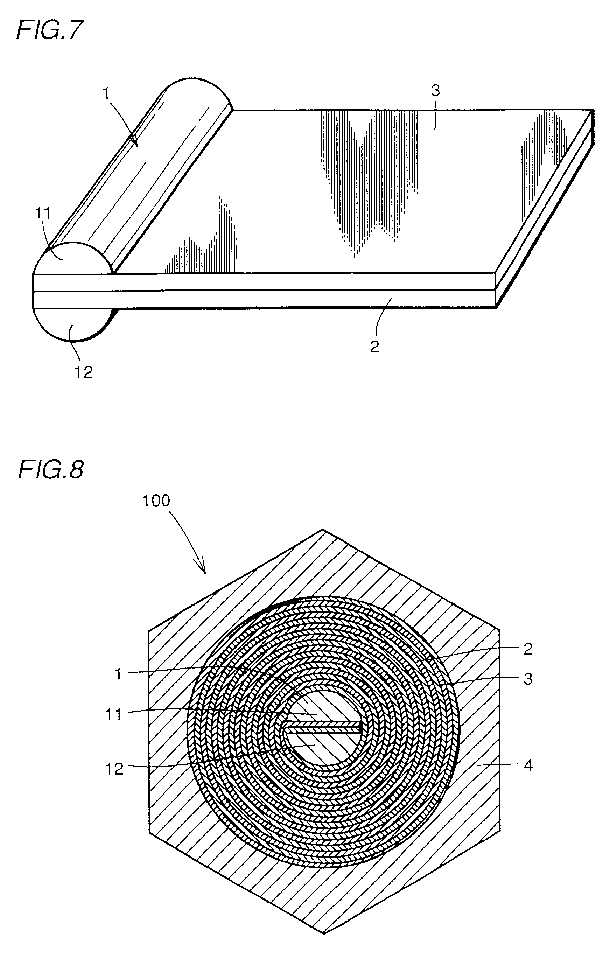

As shown in Fig. 7, a copper bar 1 comprises two copper bars 11 and 12 having semicircular cross sections. Single end portions of an Nb sheet 2 and an Al sheet 3 are held between the two copper bars 11. The lengths of the Nb sheet 2 and the Al sheet 3 to be rolled up are substantially identical to each other.

The Nb sheet 2 and the Al sheet 3 which are arranged in the aforementioned manner are superposed with each other and rolled up around the outer peripheral surface of the copper bar 1, whereby a single-filamentary hexagonal segment 100 shown in Fig. 8 can be formed. According to the embodiment 3, the length of the Nb sheet 2 to be rolled is substantially identical to that of the Al sheet 3, and hence no diffusion barrier layers are formed on the central portion and the outer peripheral portion of the rolled laminate.

Similarly to the embodiment 1, the multifilamentary wire 1000 shown in Fig. 4 can be prepared from a number of such single-filamentary hexagonal segments 100. A function and an effect which are similar to those of the embodiment 1 can be attained also in the embodiment 3.

Similarly to the embodiment 1, the multifilamentary wire 1000 shown in Fig. 4 can be prepared from a number of such single-filamentary hexagonal segments 100. A function and an effect which are similar to those of the embodiment 1 can be attained, also.

### Embodiment 4

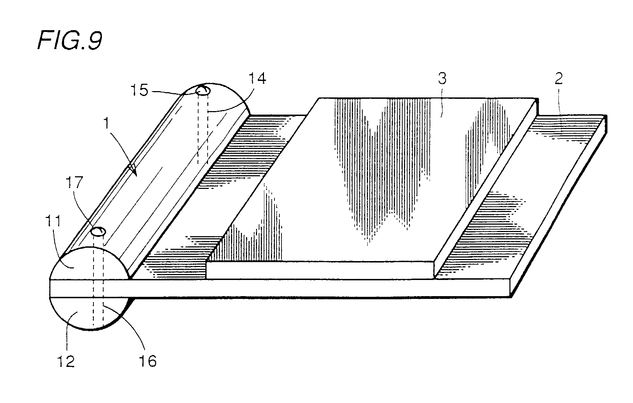

As shown in Fig. 9, a copper bar 1 comprises two copper bars 11 and 12 having semicircular cross sections. An end portion of an Nb sheet 2 is held between the two copper bars 11 and 12. Screw holes 14 and 16 are formed in both end portions of the two copper bars 11 and 12 respectively. On the other hand, the Nb sheet 2 is also provided with through holes, to coincide with these screw holes 14 and 16. Screws 15 and 17 are screwed in the screw holes 14 and 16 respectively. Thus, the end portion of the Nb sheet 2 is fixed to the copper bar 1. The Nb sheet 2 which is arranged in the aforementioned manner and an Al sheet 3 may be superposed with each other and rolled up around the outer peripheral surface of the copper bar 1, for forming a rolled laminate.

Also in the aforementioned embodiments 4 functions and effects similar to those of the embodiment 1 can be attained. In particular, stronger fixing force can be attained by employing screws and screw holes as means for fixing the end portion of the sheet to the copper bar, whereby the rolled laminate can be further readily rolled up.

### Examples

As Example 1 of the present invention, an Nb sheet 2 and an Al sheet 3 were rolled up along two copper bars 11 and 12 having semicircular cross sections, serving as core materials, to form a rolled laminate according to the embodiment 1 shown in Figs. 1 and 2. At this time, the diameter of a round bar which was formed by combining the two copper bars 11 and 12 with each other was set to be 20 times the thickness of the Nb sheet 2. Further, diffusion barrier layers 51 and 52 having prescribed thicknesses were formed on the central portion and the outer peripheral portion of the rolled laminate, which were in contact with copper portions, in order to suppress mutual diffusion of Al and copper.

As Example 2, further, the diameter of a round bar which was formed by combining two copper bars with each other was set to be 10 times the thickness of an Nb sheet, in a structure similar to that of Example 1.

As comparative examples 1 and 2, on the other hand, Nb sheets and Al sheets were rolled up along single copper bars having circular cross sections, serving as core materials, for forming rolled laminates. The diameter of the copper bar was set to be 20 times the thickness of the Nb sheet in comparative example 1 similarly to Examples 1, while the diameter of the copper bar was set to be 60 times the thickness of the Nb sheet in comparative example 2. These comparative examples 1 and 2 were also provided with diffusion barrier layers of the same thicknesses as those of Examples.

Table 1 shows possibility/impossibility of roll-up working in Examples and comparative examples. Referring to Table 1, "[Center Diameter]/[Nb Sheet Thickness]" indicates the ratio of the diameter of the round bar formed by combining two copper bars with each other or that of one copper bar to the thickness of the Nb sheet.

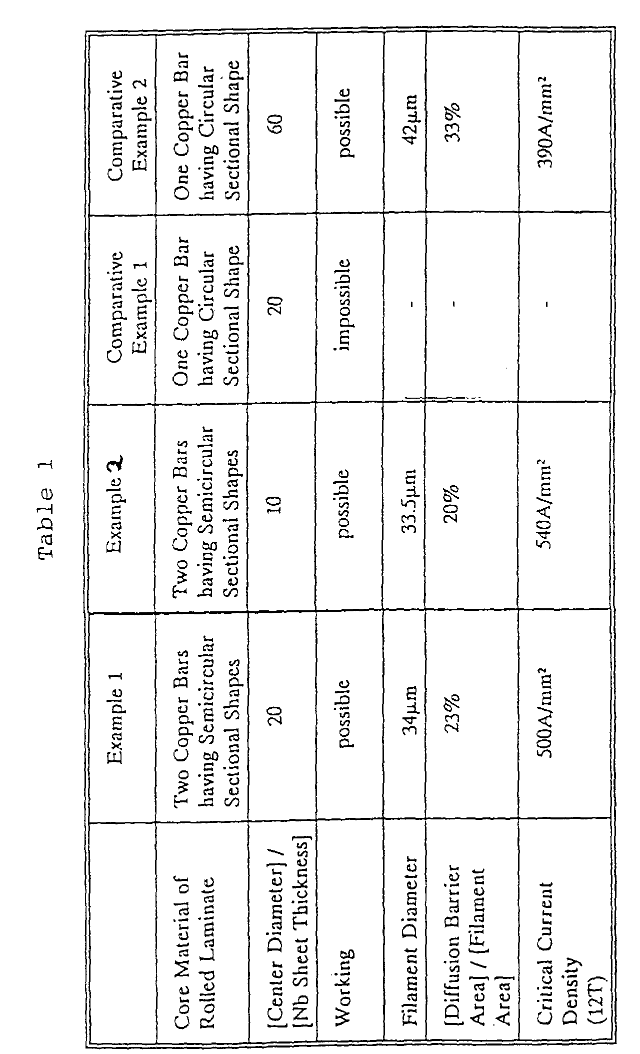

As shown in Table 1, roll-up working of the rolled laminates was possible in Examples 1 and 2 and comparative example 2, and impossible in comparative example 1. On the other hand, it was impossible to groove the copper bar which was employed as a core material. Thus, it is understood that preparation of two copper bars having semicircular sections is more advantageous than grooving of the copper bar, in view of manufacturing of the core material. While the bars having semicircular sections can be manufactured at a low cost through a step of rolling or drawing, grooving of the bar requires milling work with equipment and technique of higher degrees, and hence the manufacturing cost is increased.

The rolled laminates obtained in Examples 1 and 2 and comparative example 2 were drawn, after its outer peripheral portion is coated with copper materials and formed to have hexagonal outer peripheral surfaces. Thus, a single-filamentary hexagonal segment 100 shown in Fig. 2, for example, was obtained in each of Examples and comparative example. About 200 such single-filamentary hexagonal segments 100 were bundled and drawn to form a multifilamentary wire of 0.8 mm in diameter. An example of such a multifilamentary wire is shown in Fig. 4.

In this case, the filaments (hatched portions in Fig. 4) had outer diameters of 34 µm in Examples 1, 33.5 µm in Example 2, and 42 µm in comparative example 2. As shown in Table 1, it was possible to reduce the ratios (sectional area ratios) of [Diffusion Barrier Area]/[Filament Area] to 23 % in Example 1 and 20 % in Example 2, as compared with comparative example 2.

prescribed heat treatment was performed on these multifilamentary wires, to form superconducting phases of Nb₃Al. As to the heat treated multifilamentary wires, critical current densities under a magnetic field of 12 T and a temperature of 4.2 K were measured. Consequently, Example 1 attained critical current densities of 500 A/mm², while the critical current density of comparative example 2 was 390 A/mm². Example 2 attained a higher critical current density of 540 A/mm². Thus, according to the inventive superconducting wire, the diameter of the core material can be reduced as compared with the prior art, whereby the critical current density can be improved.

Although the present invention has been described and illustrated in detail, it is clearly understood that the same is by way of illustration and example only and is not to be taken by way of limitation, the scope of the present invention being limited only by the terms of the appended claims.

## Claims

1. A compound superconducting wire comprising:
a bar body having an outer peripheral surface; and
a rolled laminate being formed by superposing a first sheet consisting of at least one material being selected from a group consisting of an Nb metal and an alloy containing Nb and a second sheet consisting of at least one material being selected from a group consisting of an element X forming a compound exhibiting superconductivity through reaction with said Nb and an alloy containing said element X around said outer peripheral surface of said bar body and rolling up the same,
said bar body holding an end portion of at least one sheet being selected from a group consisting of said first sheet (2) and said second sheet (3),
characterized in that
said bar body (1) is formed by first and second bar bodies (11) and (12) having semicircular cross sections, said end portion of said at least one sheet and said first and second bar bodies being so combined with each other that said cross sections of said first and second bar bodies holding said end portion of said at least one sheet define a substantially circular shape.

2. The compound superconducting wire in accordance with claim 1, wherein end portions of said first sheet (2) and said second sheet (3) are held between said first and second bar bodies (11) and (12).

3. The compound superconducting wire in accordance with claim 1 or 2, wherein said bar body (1) and said at least one sheet are directly or indirectly fixed to each other by clamping force of a screw.

4. The compound superconducting wire in accordance with one of claims 1 to 3, wherein said element X is one element being selected from a group consisting of Sn and Al.

5. The compound superconducting wire in accordance with one of claims 1 to 4, wherein said bar body (1) consists of one material being selected from a group consisting of copper and a copper alloy.

6. The compound superconducting wire in accordance with one of claims 1 to 5, wherein said first sheet (2) is rolled up to be in contact with said outer peripheral surface of said bar body, said second sheet (3) being rolled up while being superposed on said first sheet (2).

7. The compound superconducting wire in accordance with claim 1, characterized by a stabilizing material layer (4) being so arranged as to enclose said rolled laminate.

8. The compound superconducting wire in accordance with claim 7, wherein said bar body (1) consists of one material being selected from a group consisting of copper and a copper alloy, said element X is one element being selected from a group consisting of Sn and Al, and said stabilizing material layer (4) consists of one material being selected from a group consisting of copper and a copper alloy, said first sheet (2) being rolled up to be in contact with said outer peripheral surface of said bar body (1) and said stabilizing material layer (4).

## Patentansprüche

1. Draht aus supraleitender Verbindung, mit:
einem Stabkörper mit einer äußeren Umfangsoberfläche; und einem aufgewickelten Laminat, das durch Aufeinanderlegen einer ersten dünnen Platte, die aus wenigstens einem Material besteht, das aus einer Gruppe ausgewählt wird, die aus einem Nb-Metall und einer Nb enthaltenden Legierung besteht, und einer zweiten dünnen Platte, die aus wenigstens einem Material besteht, das aus einer Gruppe ausgewählt wird, die aus einem Element X, das eine Supraleitfähigkeit zeigende Verbindung durch Reaktion mit dem Nb bildet, und einer das Element X enthaltenden Legierung besteht, um die äußere Umfangsoberfläche des Stabkörpers herum und Aufwickeln derselben gebildet wird,
wobei der Stabkörper einen Endabschnitt von wenigstens einer aus einer aus der ersten dünnen Platte (2) und der zweiten dünnen Platte (3) bestehenden Gruppe ausgewählten dünnen Platte hält,
dadurch **gekennzeichnet**, daß
der Stabkörper (1) aus ersten und zweiten Stabkörpern (11) und (12) gebildet wird, die halbkreisförmige Querschnitte besitzen, wobei der Endabschnitt der wenigstens einen dünnen Platte und die ersten und zweiten Stabkörper so mit einander verbunden werden, daß die Querschnitte der ersten und zweiten Stabkörper, die den Endabschnitt der wenigstens einen dünnen Platte halten, eine im wesentlichen kreisförmige Gestalt definieren.

2. Draht aus supraleitender Verbindung nach Anspruch 1, worin Endabschnitte der ersten dünnen Platte (2) und der zweiten dünnen Platte (3) zwischen den ersten und zweiten Stabkörpern (11) und (12) gehalten werden.

3. Draht aus supraleitender Verbindung nach Anspruch 1 oder 2, worin der Stabkörper (1) und die wenigstens eine dünne Platte direkt oder indirekt durch Klemmkraft einer Schraube aneinander befestigt sind.

4. Draht aus supraleitender Verbindung nach einem der Ansprüche 1 bis 3, worin das Element X ein aus einer aus Sn und Al bestehenden Gruppe ausgewähltes Element ist.

5. Draht aus supraleitender Verbindung nach einem der Ansprüche 1 bis 4, worin der Stabkörper (1) aus einem aus einer aus Kupfer und einer Kupferlegierung bestehenden Gruppe ausgewählten Material besteht.

6. Draht aus supraleitender Verbindung nach einem der Ansprüche 1 bis 5, worin die erste dünne Platte (2) so aufgewickelt wird, daß sie in Kontakt mit der äußeren Umfangsoberfläche des Stabkörpers steht, wobei die zweite dünne Platte (3) aufgewickelt wird, während sie auf die erste dünne Platte (2) gelegt wird.

7. Draht aus supraleitender Verbindung nach Anspruch 1, gekennzeichnet durch eine stabilisierende Materialschicht (4), die so angeordnet wird, daß sie das aufgewickelte Laminat umschließt.

8. Draht aus supraleitender Verbindung nach Anspruch 7, worin der Stabkörper (1) aus einem aus einer aus Kupfer und einer Kupferlegierung bestehenden Gruppe ausgewählten Material besteht, das Element X ein aus einer aus Sn und Al bestehenden Gruppe ausgewähltes Element ist, und die stabilisierende Materialschicht (4) aus einem aus einer aus Kupfer und einer Kupferlegierung bestehenden Gruppe ausgewählten Material besteht, wobei die erste dünne Platte (2) so aufgewickelt wird, daß sie in Kontakt mit der äußeren Umfangsoberfläche des Stabkörpers (1) und der stabilisierenden Materialschicht (4) steht.

## Revendications

1. Fil supraconducteur composite comprenant :
un corps en forme de barre possédant une surface périphérique extérieure ; et
un stratifié laminé enroulé qui est formé par superposition d'une première feuille formée au moins d'un matériau choisi dans un groupe comprenant un métal Nb et un alliage contenant du Nb et d'une seconde feuille formée d'au moins un matériau choisi dans le groupe comprenant un élément X formant un composé présentant une supraconductivité par réaction avec ledit Nb et un alliage contenant ledit élément X entourant ladite surface périphérique extérieure dudit corps en forme de barre, et par enroulement de ces feuilles,
ledit corps en forme de barre retenant une partie d'extrémité d'au moins une feuille choisie dans un groupe comprenant ladite première feuille (2) et ladite seconde feuille (3),
caractérisé en ce que
ledit corps en forme de barre (1) est formé par des premier et second corps en forme de barres (11 et 12) possédant des sections transversales semi-circulaires, ladite partie d'extrémité de ladite au moins une feuille et lesdits premier et second corps en forme de barres étant associés de telle sorte que lesdites sections transversales desdits premier et second corps en forme de barres retenant ladite partie d'extrémité de ladite au moins une feuille définissent une forme essentiellement circulaire.

2. Fil supraconducteur composite selon la revendication 1, dans lequel des parties d'extrémité de ladite première feuille (2) et ladite seconde feuille (3) sont retenues entre lesdits premier et second corps en forme de barres (11 et 12).

3. Fil supraconducteur composite selon la revendication 1 ou 2, dans lequel ledit corps en forme de barre (1) et ladite au moins une feuille sont fixés directement ou indirectement l'un à l'autre par la force de serrage d'une vis.

4. Fil supraconducteur composite selon l'une des revendications 1 à 3, dans lequel ledit élément X est un élément choisi dans un groupe constitué du Sn et du Al.

5. Fil supraconducteur composite selon l'une des revendications 1 à 4, dans lequel ledit corps en forme de barre (1) est formé d'un matériau choisi dans un groupe comprenant le cuivre et un alliage de cuivre.

6. Fil supraconducteur composite selon l'une des revendications 1 à 5, dans lequel ladite première feuille (2) est enroulée de manière à être en contact avec ladite surface périphérique extérieure dudit corps en forme de barre, ladite seconde feuille (3) étant enroulée tout en étant superposée à ladite première feuille (2).

7. Fil supraconducteur composite selon la revendication 1, caractérisé par une couche d'un matériau de stabilisation (4) disposée de manière à refermer ledit stratifié enroulé.

8. Fil supraconducteur composite selon la revendication 7, dans lequel ledit corps en forme de barre (1) est formé d'un matériau choisi dans un groupe comprenant le cuivre et un alliage de cuivre, ledit élément X étant un élément choisi dans un groupe comprenant le cuivre et un alliage de cuivre, ledit élément X est un élément choisi dans un groupe comprenant le Sn et le Al, et ladite couche de matériau de stabilisation (4) est formée d'un matériau choisi dans un groupe comprenant le cuivre et un alliage de cuivre, ladite première feuille (2) étant enroulée de manière à être en contact avec ladite surface périphérique extérieure dudit corps en forme de barre (11) et ladite couche de matériau de stabilisation (4).
